# EUROPEAN PATENT APPLICATION

(11) **EP 4 050 648 A1**
(43) Date of publication of application: **31.08.2022**
(21) Application number: 20879597.1
(22) Date of filing: 06.10.2020
(51) Int. Cl.: H01L 23/48, H01L 21/8234, H01L 27/06, H01L 27/088, H01L 29/06, H01L 29/78, H01L 21/329, H01L 29/866, H02M 7/21

(54) **SEMICONDUCTOR DEVICE, RECTIFYING ELEMENT USING SAME, AND ALTERNATOR**

(30) Priority: 24.10.2019 JP 2019193215
(71) Applicant: Hitachi Power Semiconductor Device, Ltd., Hitachi-shi, Ibaraki 319-1221 (JP)
(72) Inventor: SHIRAISHI Masaki, Tokyo 100-8280 (JP); SAKANO Junichi, Tokyo 100-8280 (JP)
(74) Representative: Mewburn Ellis LLP
(86) International application number: PCT/JP2020/037858
(87) International publication number: WO 2021/079735

(57) **Abstract**

A semiconductor device that is equipped with a MOSFET with a Zener diode embedded and capable of achieving both improvement in the surge resistance and the low on-resistance of the MOSFET is provided. The semiconductor device equipped with a MOSFET with a Zener diode embedded includes an active region in which the MOSFET operates, and a peripheral region that is disposed outside of the active region and holds a withstand voltage of a chip peripheral portion, in which the active region includes a first region including a chip central portion and a second region disposed outside of the first region, and a withstand voltage of the first region is lower than a withstand voltage of the second region and a withstand voltage of the peripheral region.

## Description

### Technical Field

The present invention relates to the structures of semiconductor devices, and more particularly, relates to technologies effective when applied to semiconductor devices for electric power control that are mounted on in-vehicle alternators (AC generators) and required to have high reliability.

### Background Art

A rectifying circuit, which coverts a generated AC voltage to a DC voltage by rectifying the AC voltage and charges batteries, is installed in an alternator (an AC generator) that generates electric power in a vehicle. Diodes have been used up to now as rectifying elements used in this rectifying circuit.

In a rectifying element using diodes, for example as shown by PTL 1, a terminal of the upper surface of a diode chip is connected to a lead electrode and a terminal of the lower surface of the diode chip is connected to a base electrode. The outer shape of the package composed of the base electrode is circular, and the circular package is fixed to the electrode plate of an alternator by soldering or press fitting.

Using the circular package makes it possible to fix the diode to the electrode plate of the alternator, so that it becomes easier to assemble the rectifying portion of the alternator. It is necessary to fix as many as 6 to 12 rectifying elements per alternator to the electrode plate of an alternator, so that it is important that the rectifying elements can be easily fixed to the alternator for achieving the simplification of the assembly processes of the alternator and reduction of the cost thereof.

Although a diode is cheap, the diode has a forward voltage drop, which leads to a large power loss. To cope with this, in recent years, MOSFETs have begun to be used as rectifying elements for alternators instead of diodes. It is possible to put into practice rectifying elements that do not have forward voltage drops, the forward currents of which rise at 0 volt, and the power losses of which are small by executing synchronous rectification on MOSFETs.

For example, PTL 2 discloses a rectifying element that includes a MOSFET, a control IC for controlling the MOSFET, a capacitor for supplying electric power to the control IC in a conventional circular package with two terminals and that can be used for reducing the power loss of an alternator with using the conventional package of the same shape by autonomously judging whether the MOSFET is on or off with reference to a voltage between the source and the drain of the MOSFET.

In addition, it is necessary that, when a phenomenon called a load dump that an output terminal of an alternator disengaging or a terminal of a battery disengages occurs at the time the alternator generates electric power, energy generated by the electric power generation needs to be dissipated inside the alternator so that a high voltage is prevented from being outputted to the output terminal of the alternator. Therefore, PTL 2 also discloses a rectifying element that includes a Zener diode connected in parallel with a MOSFET and that dissipates surge energy generated at the time load dump occurs at the Zener diode.

In the case of a Zener diode being mounted in parallel with a MOSFET to dissipate surge energy, a mounting area for the MOSFET becomes small, which brings a limit to the high output of the alternator. To solve this problem, PTL 3 discloses an alternator that can generate a high output while securing a surge resistance by mounting a MOSFET that embeds Zener diodes in the active region of the MOSFET in which the breakdown voltage of each of the Zener diodes is lower than the breakdown voltage of the MOSFET that is avalanched at the time a surge occurs.

Furthermore, PTL 4 discloses a semiconductor device that includes a Schottky junction and a pn junction and that can secure a surge resistance by setting the breakdown voltage of the pn junction portion lower than the breakdown voltage of the Schottky junction and the breakdown voltage of the pn junction of a guard ring portion.

### Citation List

### Patent Literature

PTL 1: Japanese Patent Application Laid-Open Publication No. Hei 10-215552
PTL 2: Japanese Patent Application Laid-Open Publication No. 2015-116053
PTL 3: Japanese Patent Application Laid-Open Publication No. 2019-033144
PTL 4: Japanese Patent Application Laid-Open Publication No. 2012-174878

### Summary of Invention

### Technical Problem

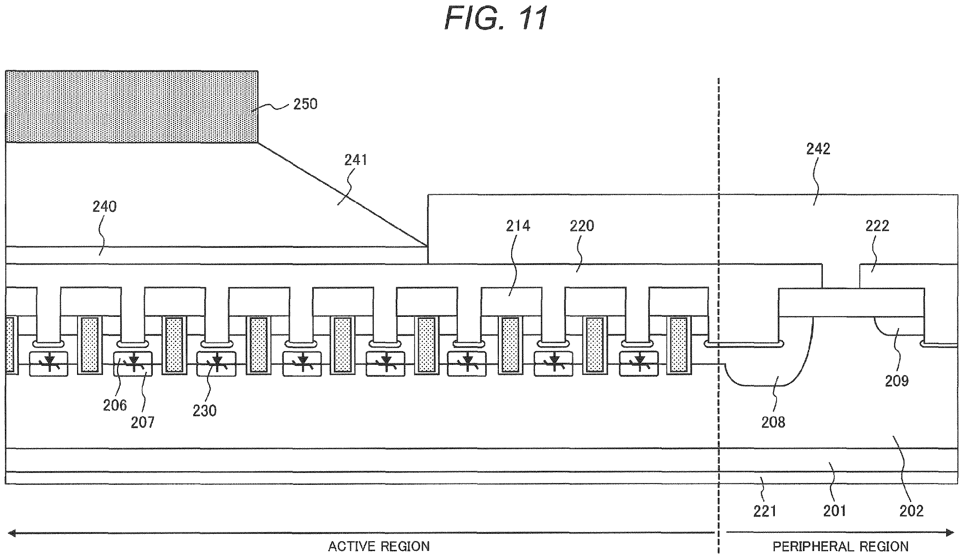

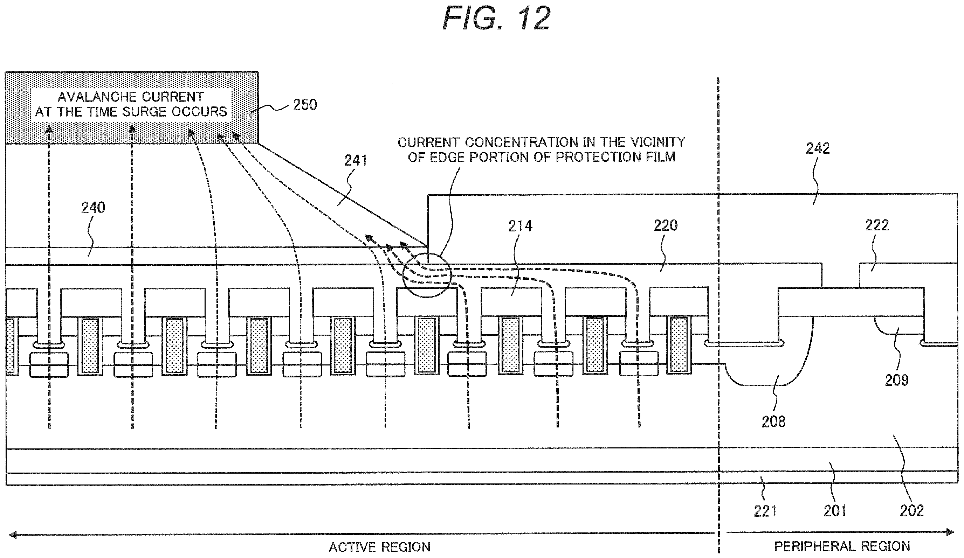

Each of Figure 11 and Figure 12 shows a cross-sectional structure of a typical conventional MOSFET with Zener diodes embedded and an avalanche current at the time a surge occurs.

Each of PTL 3 and PTL 4 shows a structure that can secure a surge resistance by being provided with a fabric having a low breakdown voltage in the active region of the structure. In an actual structure, however, as shown in Figure 11, the active region is formed even below a protection film 242 in the peripheral region of the structure, and when a surge occurs, an avalanche current is generated even in the active region below the protection film 242 as shown in Figure 12.

Since an avalanche current flow through a plating layer 240 connected to the opening of the protection film 242, a solder layer 241, and a copper block 250, the avalanche current concentrates around the opening of the protection film 242, therefore there arises a problem that the temperature rises and the MOSFET breaks down.

On the other hand, if the MOSFET is fabricated in such a way that an active region is formed only below the opening of the protection film 242, the area of the active region becomes smaller, which leads to a problem that the on-resistance of the MOSFET becomes higher.

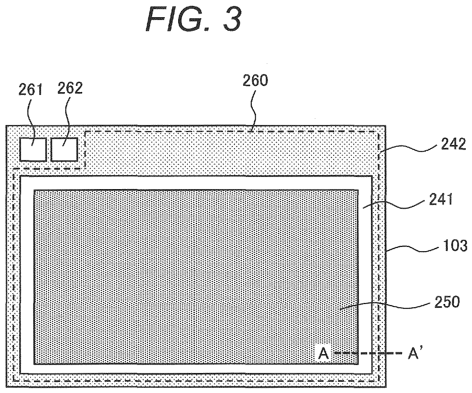

Figure 3 shows a planar structure of a MOSFET with Zener diodes embedded according to the present invention, where the above MOSFET will be described later. As shown in Figure 3, in the case where a copper block 250 and the opening of a protection film 242 have rectangular shapes respectively due to restrictions on the processing of the copper block 250 to be mounted, it is particularly noteworthy that the active region in the lower portion of the protection film 242 next to pads (a gate pad 261 and a source sense pad 262) becomes larger, and a problem of current concentration and a problem of the increase of an on-resistance when the active region below the protection film are removed become more remarkable.

Therefore, an object of the present invention is to provide a semiconductor device that is equipped with MOSFETs each of which embeds a Zener diode and capable of achieving both improvement in the surge resistance and the low on-resistance of the MOSFET.

### Solution to Problem

In order to solve the abovementioned problem, what is provided by the present invention is a semiconductor device that is equipped with a MOSFET with a Zener diode embedded, the semiconductor device including: an active region in which the MOSFET operates; and a peripheral region that is disposed outside of the active region and holds a withstand voltage of a chip peripheral portion, wherein the active region includes a first region including a chip central portion and a second region disposed outside of the first region, and a withstand voltage of the first region is lower than a withstand voltage of the second region and a withstand voltage of the peripheral region.

In addition, the present invention is characterized in that a rectifying element used for an alternator, the rectifying element including: a first external electrode having an outer peripheral portion that is approximately circular viewed from above and an approximately circular pedestal housed in the outer peripheral portion; a resin-sealed inner package disposed on the pedestal; and a second external electrode disposed on an opposite side of the first external electrode with the inner package therebetween, the inner package including: a semiconductor device; a control IC chip that brings in voltages or currents of a drain electrode and a source electrode of the semiconductor device and drives a gate of the semiconductor device on the basis of the brought-in voltages or currents; a capacitor for supplying electric power to the control IC; a drain frame connected to the drain electrode; and a copper block connected to the source electrode, wherein surfaces of the drain frame and the copper block are exposed on a surface of the inner package without being resin-sealed, the first external electrode is electrically connected to one of the drain frame and the copper block via a bonding material, the second external electrode is electrically connected to the other of the drain frame and the copper block via a bonding material, and the semiconductor device is the abovementioned semiconductor device.

Furthermore, the present invention is also an alternator characterized by being equipped with the abovementioned rectifying element.

### Advantageous Effects of Invention

According to the present invention, a semiconductor device that is equipped with MOSFETs each of which embeds a Zener diode and capable of achieving both improvement in the surge resistance and the low on-resistance of each of the MOSFETs can be put into practice.

With this, the semiconductor device that is equipped with MOSFETs each of which embeds a Zener diode, and a rectifying element and an alternator (an AC generator) each of which uses the semiconductor device can achieve their high reliabilities and high performances (low-loss performances) respectively.

Other problems, configurations, and advantageous effects will be explicitly shown by the descriptions of the following embodiments.

### Brief Description of Drawings

Figure 1 is a diagram showing a cross-sectional structure of a MOSFET with Zener diodes embedded according to Example 1 of the present invention.
Figure 2 is a diagram showing an avalanche current of the MOSFET with Zener diodes embedded according to Example 1 of the present invention at the time a surge occurs.
Figure 3 is a diagram showing a planar structure of the MOSFET with Zener diodes embedded according to Example 1 of the present invention.
Figure 4 is a diagram showing a cross-sectional structure of a MOSFET with Zener diodes embedded according to Example 2 of the present invention.
Figure 5 is a diagram showing an avalanche current of the MOSFET with Zener diodes embedded at the time a surge occurs according to Example 2 of the present invention.
Figure 6 is a top view of a rectifying element for an alternator according to Example 3 of the present invention.
Figure 7 is a cross-sectional view along the line B-B' of Figure 6.
Figure 8 is a cross-sectional view along the line C-C' of Figure 6.
Figure 9 is a circuit diagram of a rectifying element for an alternator according to Example 3 of the present invention.
Figure 10 is a circuit diagram of an alternator according to Example 3 of the present invention.
Figure 11 is a diagram showing a cross-sectional structure of a conventional MOSFET with Zener diodes embedded.
Figure 12 is a diagram showing an avalanche current of the conventional MOSFET with Zener diodes embedded at the time a surge occurs.

### Description of Embodiments

Examples of the present invention will be explained with reference to the accompanying drawings. Here, in the following drawings, the same components are given the same reference signs, and detailed explanations about redundant parts will be omitted.

### <Example 1>

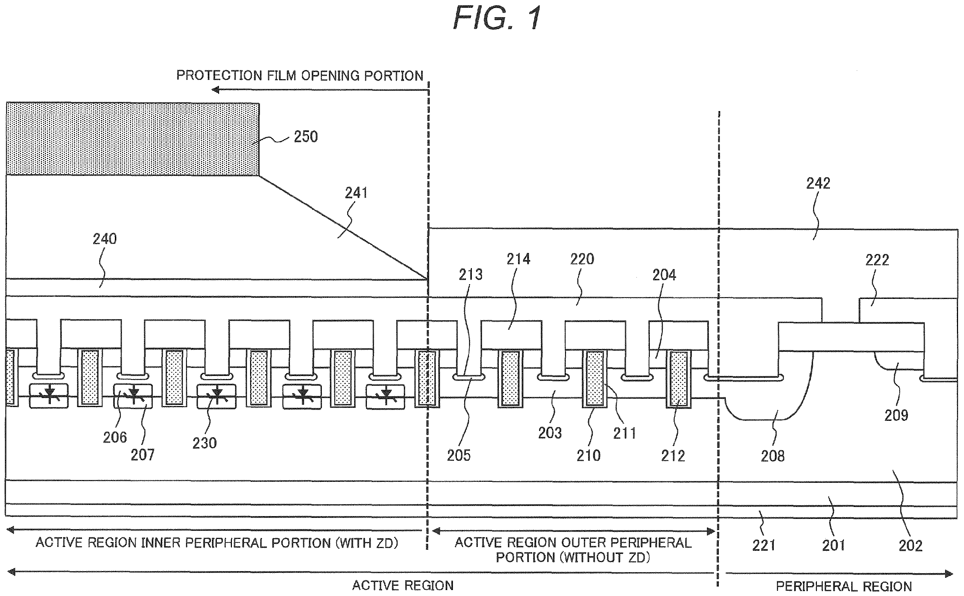

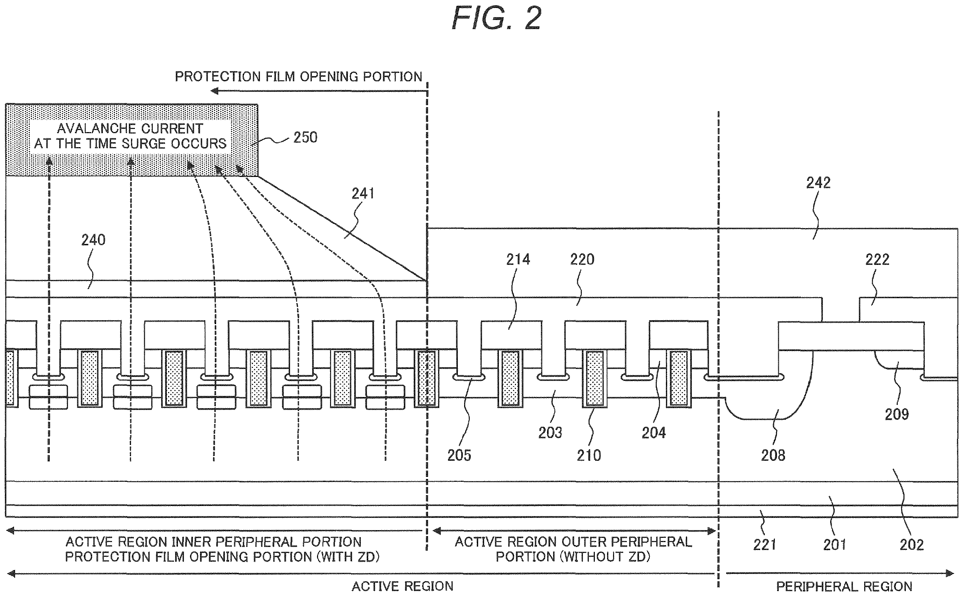

A MOSFET with Zener diodes embedded according to Example 1 of the present invention will be explained with reference to Figure 1 to Figure 3. Figure 1 shows a cross-sectional structure of the MOSFET with Zener diodes embedded according to this example. Figure 2 shows an avalanche current at the time a surge occurs. Figure 3 shows a planar structure of the chip of the MOSFET with Zener diodes embedded according to this example, and each of Figure 1 and Figure 2 corresponds to a cross-sectional view along the line A-A' of Figure 3.

As shown in Figure 1, the MOSFET with Zener diodes embedded according to this example has an active region of the MOSFET and a peripheral region outside of the active region. In the active region, an n⁺ substrate 201 and an n⁻epi layer 202 are formed on a drain electrode 221, and a p-type channel layer 203 is formed on the n⁻ epi layer 202. In addition, a trench gate 210 that penetrates the p-type channel layer 203 from a semiconductor surface and reaches the n⁻ epi layer 202 is formed, and the trench gate 210 is composed of a gate oxide film 211 and a polysilicon electrode 212 filled in a trench.

An n⁺ source layer 204 is formed on the semiconductor surface, a trench 213 for contact that penetrates the n⁺ source layer 204 and reaches the channel layer 203 is formed, and a p⁺ contact layer 205 is formed just under the trench 213. A source electrode 220 is formed on the surface of the semiconductor layer via the trench 213 and an interlayer insulating film 214.

An active region includes an active region inner peripheral portion and an active region outer peripheral portion outside of the active region inner peripheral portion. A Zener diode 230 is formed under the trench 213 in the active region inner peripheral portion, and no Zener diode is provided under the trench 213 in the active region outer peripheral portion. In the active region inner peripheral portion, a plating layer 240 is formed on the source electrode 220, and a copper block 250 is connected to the plating layer 240 via a solder layer 241. On the other hand, in the active region outer peripheral portion, a protection film 242 extending to the peripheral region is formed on the source electrode 220.

The Zener diode 230 formed in the active region inner peripheral portion is composed of a junction between a p layer 206 having a concentration higher than a p-type channel layer 203 and an n layer 207 having a higher concentration than the n⁻ epi layer 202, and the withstand voltage of the active region inner peripheral portion, in which the Zener diode 230 is formed, is set lower than the withstand voltages of the active region outer peripheral portion and the peripheral region in which no Zener diode is formed.

Further, since the Zener diode 230 is formed under the trench 213 and in the center portion of the p-type channel layer 203, it is possible to make most of a current flowing when the Zener diode is avalanched easily flow through the p⁺ contact layer 205 and the remaining current passing through the lower portion of the n⁺ source layer 204 small, so that the operation of a parasitic npn transistor can be prevented and a high avalanche resistance can be realized.

In addition, there is a deep p layer 208 in the peripheral region, so that a depletion layer is widened to the outer periphery of the deep p layer 208 when a voltage is applied, and the withstand voltage can be secured. Further, the source electrode 220 extends to a position where the deep p layer 208 is covered, and serves as a field plate, which alleviates an electric field at the end of the deep p layer 208.

At the end of the chip, an n⁺ field stop layer (a channel stopper layer) 209 and a guard ring 222 are formed to prevent the depletion layer from reaching the end of the chip that includes many defects and the lifetime of which is short, so that the withstand voltage is held.

Although the withstand voltage of the Zener diode 230 in the active region inner peripheral portion is set lower than the withstand voltages of the active region outer peripheral portion and the peripheral region, the Zener diode 230 is avalanched and a current flow when a surge occurs, so that the temperature of the active region inner peripheral portion rises, which increases the withstand voltage of the Zener diode 230.

On the other hand, since an avalanche current does not flow through the active region outer peripheral portion and the peripheral region, increases in the temperatures thereof become smaller than an increase in the temperature of the active region inner peripheral portion. In order for the Zener diode 230 to surely absorb the surge energy even in such a case, the Zener diode 230 is set so that the withstand voltage of the Zener diode 230 becomes lower than the withstand voltages of the active region outer peripheral portion and the peripheral region even when the temperature rises.

As shown in Figure 1, in order to form the Zener diode 230 only in the active region inner peripheral portion, when the p layer 206 and the n layer 207 composing the Zener diode 230 are formed by ion implantation after forming the trench 213 for contact, the active region outer peripheral portion and the peripheral region are covered with a photomask, so that the Zener diode 230 can be selectively formed only in the active region inner peripheral portion.

In other words, the MOSFET with Zener diodes embedded according to this example includes: the active region in which the MOSFET operates; and the peripheral region that is disposed outside of the active region and holds the withstand voltage of a chip peripheral portion, in which the active region includes the first region (the active region inner peripheral portion) including a chip central portion and the second region (the active region outer peripheral portion) disposed outside the first region, and the withstand voltage of the first region (the active region inner peripheral portion) is set to become lower than the withstand voltage of the second region (the active region outer peripheral portion) and the withstand voltage of the peripheral region.

Furthermore, the withstand voltage of the first region (the active region inner peripheral portion) is set to become lower than the withstand voltage of the second region (the active region outer peripheral portion) and the withstand voltage of the peripheral region even when a surge occurs in the MOSFET with Zener diodes embedded (the semiconductor device), and the temperature of the first region (the active region inner peripheral portion) rises higher than the temperature of the second region(the active region outer peripheral portion).

In addition, plural unit cells (trench gates 210) are arranged in the first region (the active region inner peripheral portion) and the second region (the active region outer peripheral portion). A Zener diode 230 is formed to each unit cell (each trench gate 210) of the first region (the active region inner peripheral portion), and the withstand voltage of the Zener diode 230 is set to become lower than the withstand voltage of the second region (the active region outer peripheral portion) and the withstand voltage of the peripheral region.

The advantageous effect of the improvement of a surge resistance according to this example will be explained with reference to Figure 2. Figure 2 conceptually shows an avalanche current at the time a surge occurs in the structure of the MOSFET with Zener diodes embedded shown in Figure 1. As described above, since the Zener diodes 230 are formed in the active region inner peripheral portion (the opening of the protection film), the withstand voltage of the active region inner peripheral portion becomes lower than the withstand voltages of the active region outer peripheral portion and the peripheral region, and the avalanche current flow only in the active region inner peripheral portion.

Since there is no protection film 242 in the upper portion of the active region inner peripheral portion, the avalanche current flow through the plating layer 240, the solder layer 241, and the copper block 250 without being concentrated at the end of the opening of the protection film. Since there is no current concentration, a temperature rise due to current concentration can be suppressed, and a surge resistance can be secured. On the other hand, in the normal operation, the active region outer peripheral portion also operates as an active region, so that the on-resistance does not increase.

Figure 3 shows a plan view of the MOSFET chip with Zener diodes embedded according to this example. The MOSFET chip 103 with Zener diodes embedded has a rectangular shape with a gate pad 261 and a source sense pad 262. The copper block 250 electrically connected to the source electrode 220 is connected to the opening of the protection film 242 via the solder layer 241. For ease of processing of the copper block 250, the copper block 250 and the opening of the protection film 242 have rectangular shapes respectively as shown in Figure 3.

The active region 260 is disposed as shown by a dotted line in Figure 3, and in particular, the active region under the protection film 242 in a region next to the pads (the gate pad 261 and the source sense pad 262) is wide, so that a current at the time an avalanche occurs is concentrated at the end of the opening of the protection film 242. In this example, however, since no Zener diodes are formed in the active region outer peripheral portion under the protection film 242, current concentration can be prevented.

### <Example 2>

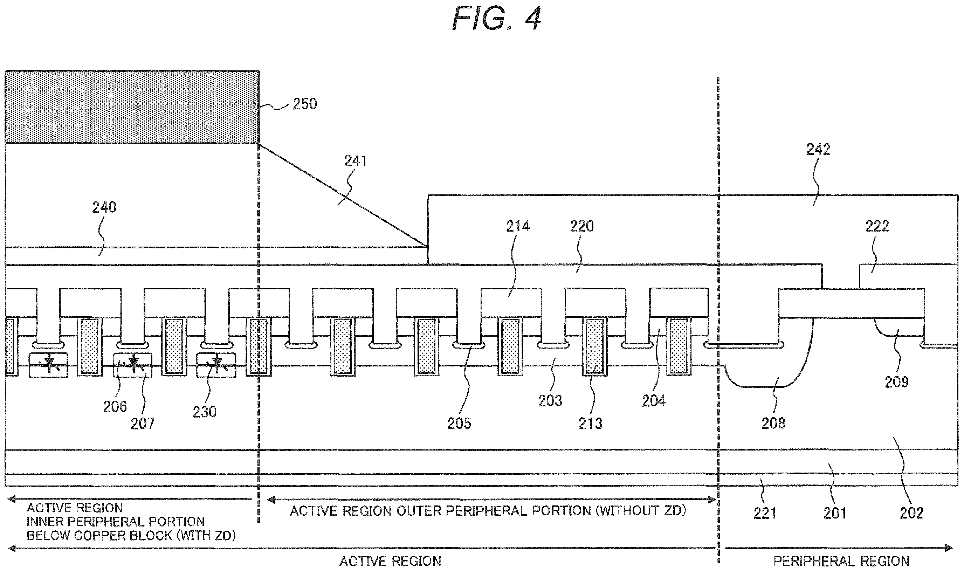

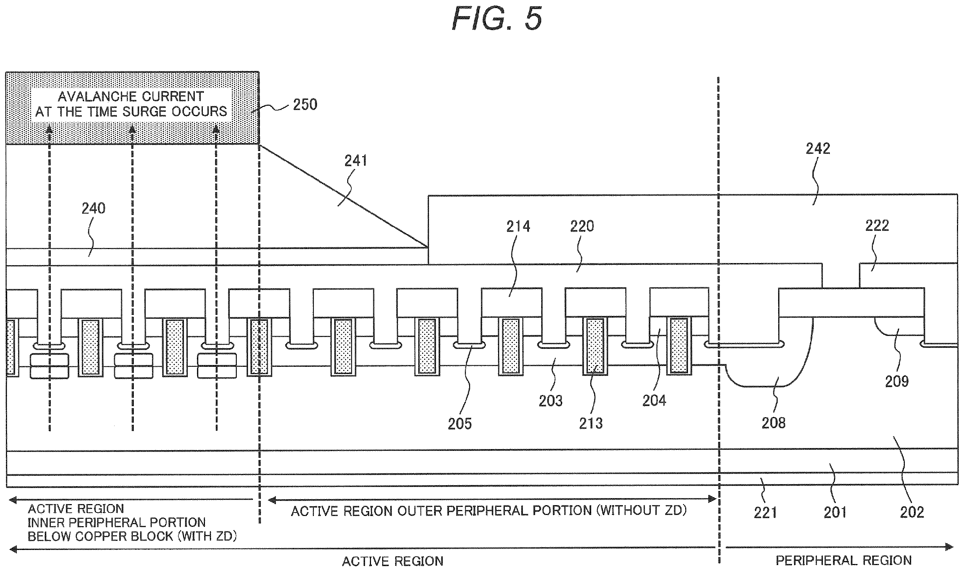

A MOSFET with Zener diodes embedded according to Example 2 of the present invention will be explained with reference to Figure 4 and Figure 5. Figure 4 shows a cross-sectional structure of the MOSFET with Zener diodes embedded according to this example. Figure 5 shows an avalanche current at the time a surge occurs.

As shown in Figure 4, the MOSFET with Zener diodes embedded according to this example is characterized in that an active region inner peripheral portion in which the Zener diodes 230 are formed is formed only below a copper block 250. In other words, a first region (the active region inner peripheral portion) is disposed only just below a copper terminal for wiring (the copper block 250) provided in the opening of the protection film 242.

In other words, in Example 1 (Figure 1), the Zener diodes 230 are formed even in an area that is below the opening of the protection film 242 and not below the copper block 250. In this example (Figure 4), the Zener diodes 230 are not formed in the area that is below the opening of the protection film 242 and not below the copper block 250.

As shown in Figure 5, when a surge occurs, an avalanche current flow linearly toward the copper block 250, so that current concentrations at the end of the solder layer 241 and at the end of the copper block 250 can be suppressed, and a surge resistance can be improved.

### <Example 3>

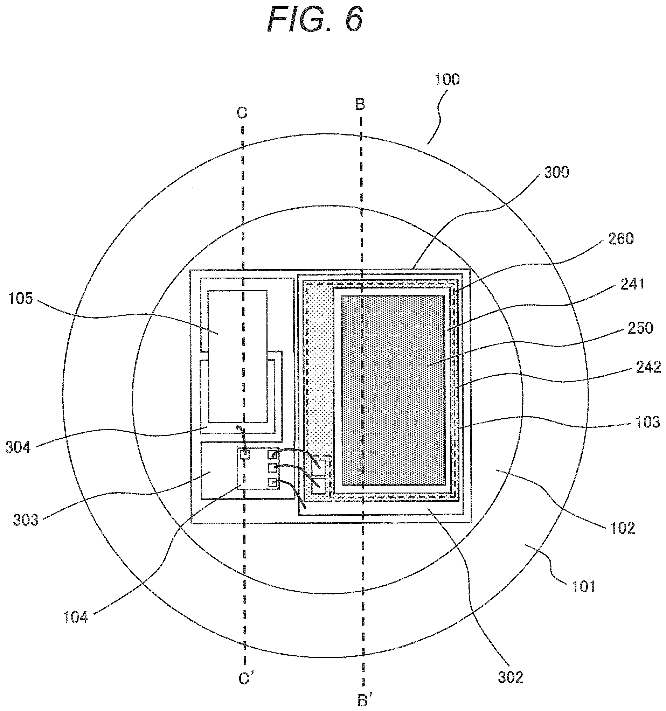

A rectifying element for an alternator and an alternator (an AC generator) according to Example 3 of the present invention will be explained with reference to Figure 6 to Figure 10.

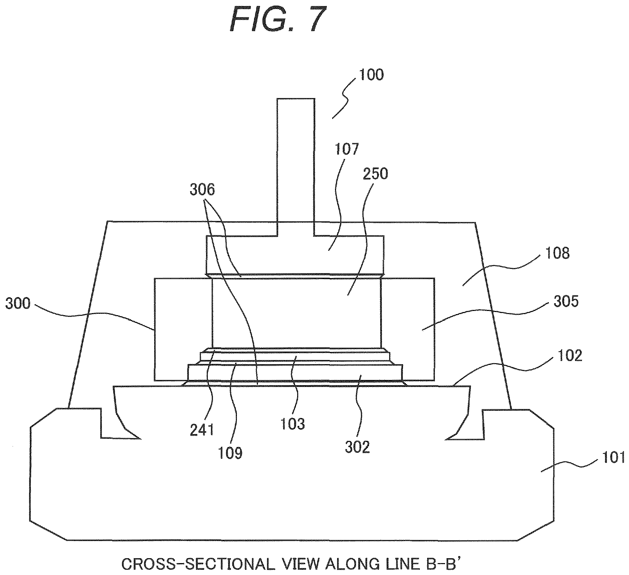

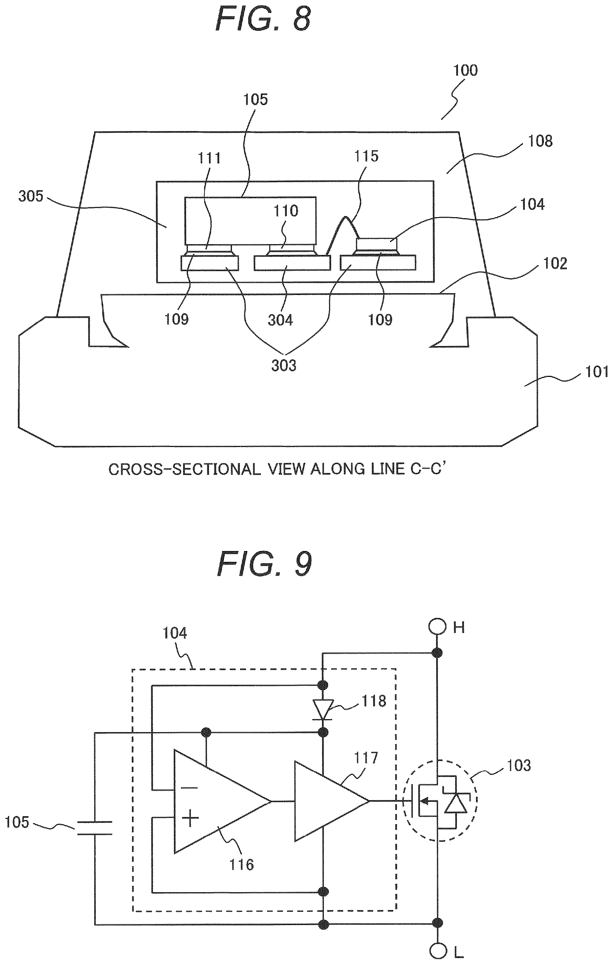

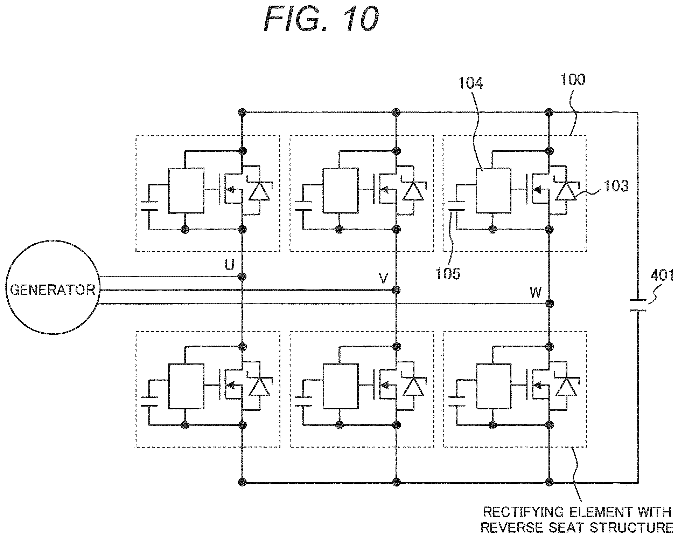

Figure 6 shows a top view of a rectifying element 100 for an alternator on which the MOSFET with Zener diodes embedded, which is explained in Example 1 or in Example 2 of the present invention, is mounted. Figure 7 shows a cross-sectional view of the rectifying element 100 along the line B-B', and Figure 8 shows a cross-sectional view of the rectifying element 100 along the line C-C'. Figure 9 shows a circuit diagram of the rectifying element 100, and Figure 10 shows a circuit diagram of an alternator (an AC generator) on which the rectifying elements 100 are mounted.

As shown in Figure 6 to Figure 8, the rectifying element 100 according to this example includes a base electrode 101 having a circular outer peripheral portion, a pedestal 102 provided on the base electrode 101, and a rectangular inner package 300 provided on the pedestal 102.

The internal package 300 includes: a MOSFET chip 103 with a Zener diode embedded; a control IC chip 104; a capacitor 105; a copper block 250 mounted on the MOSFET chip 103 with a Zener diode embedded; a drain frame 302 on which the MOSFET chip 103 with a Zener diode embedded is mounted; a lead frame 303 on which a control IC chip 104 is mounted and a lead frame 304 on which a capacitor 105 are mounted; and the whole of the internal package is covered with a resin 305.

The upper surface of the copper block 250 and the lower surface of the drain frame 302 are exposed on the surface of the internal package 300 without being covered with the resin 305. The upper surface of the copper block 250 is connected to a lead electrode 107 via a bonding material 306, and the lower surface of the drain frame 302 is connected to the pedestal 102 via a bonding material 306. Further, the low voltage sides of the control IC chip 104 and the capacitor 105 are connected to the same lead frame 303, and the high voltage side of the capacitor 105 is connected to the lead frame 304.

In addition, there are two types of rectifying elements for an alternator: one is a rectifying element with a normal seat structure; and the other is a rectifying element with a reverse seat structure. The directions of currents flowing through the former and the latter are opposite to each other, and the structure of the rectifying element 100 shown in Figure 6 is the normal seat structure. Although the reverse seat structure is not shown, the configuration of the internal package 300 of the reverse seat structure is the same as that of the normal seat structure, and the copper block 250 is connected to the pedestal 102 and the drain frame 302 is connected to the lead electrode 107.

Figure 9 shows a circuit configuration of the rectifying element 100. In the circuit shown in Figure 9, an L terminal is the base electrode 101 and an H terminal is the lead electrode 107. The MOSFET chip 103 with a Zener diode embedded, the control IC chip 104, and the capacitor 105 are wired as shown in FIG. 9.

The control IC chip 104 includes a comparator 116, a gate driver 117, and a diode 118. One input terminal of the comparator 116 is connected to the H terminal, and the other input terminal of the comparator 116 is connected to the L terminal. The output terminal of the comparator 116 is connected to the input terminal of the gate driver 117, and the output terminal of the gate driver 117 is connected to the gate electrode of the MOSFET chip 103 with a Zener diode embedded.

Furthermore, the high-voltage side terminal 110 of the capacitor 105 (see Figure 8) is connected to the power supply terminal of the comparator 116 and the power supply terminal of the gate driver 117, and the low-voltage side terminal 111 of the capacitor 105 (see Figure 8) is connected to the L terminal. In addition, a diode 118 for preventing the charge of the capacitor 105 from flowing back is inserted between the capacitor 105 and the H terminal.

The circuit shown in Figure 9 operates as follows. When the voltage of the H terminal becomes lower than the voltage of the L terminal, the comparator 116 outputs a signal having a high voltage (or a signal having a low voltage), and the gate driver 117 into which the signal is input raises the voltage of the gate electrode of the MOSFET chip 103 with a Zener diode embedded to make the MOSFET chip 103 with a Zener embedded in an on-state.

On the other hand, when the voltage of the H terminal becomes higher than the voltage of the L terminal, the comparator 116 outputs a signal having a low voltage (or a signal having a high voltage), and the driver 117 into which the signal is input lowers the voltage of the gate electrode of the MOSFET chip 103 with a Zener diode embedded to make the MOSFET chip 103 with a Zener embedded in an off-state.

In other words, on the basis of a magnitude relationship between the voltage of the H terminal and the voltage of the L terminal, the MOSFET chip 103 with a Zener diode embedded is turned on and off autonomously. The capacitor 105 supplies a power supply voltage to the comparator 116 and the gate driver 117.

Figure 10 shows an example in which rectifying elements 100 in which the MOSFET 103 with a Zener diode embedded according to the present invention are applied to an alternator (an AC generator). The alternator generates AC power (voltage) using a generator, rectifies the AC power (voltage) by a rectifier, and generates and outputs DC power (voltage).

Figure 10 shows the configuration of a three-phase full-wave rectifying circuit (400) using six rectifying elements 100. The circuit is equipped with three rectifying elements 100 with a normal seat structure and three rectifying elements with a reverse seat structure (not shown), and a battery 401.

As shown in Figure 10, rectifying elements with a normal seat structure and rectifying elements with a reverse seat structure are connected in series, and three connecting point are connected to the U-phase, the V-phase, and the W-phase of a three-phase AC current respectively. The three-phase full-wave rectifying circuit (400) converts the AC current from the generator into a DC current, and outputs DC power (voltage) to the battery 401.

In addition, the present invention is not limited to the above-described examples, and the present invention may include various kinds of modification examples. For example, the above examples have been described in detail in order to explain the present invention in an easily understood manner, and the present invention is not necessarily limited to examples that include all configurations that have been described so far. Furthermore, a part of the configuration of one example can be replaced with a part of the configuration of another example, and it is also possible to add the configuration of one example to the configuration of another example. In addition, it is possible to delete a part of the configuration of each example, to add another configuration to a part of the configuration of each example, or to replace a part of the configuration of each example with another configuration.

### Reference Signs List

- 100: Rectifying Element (for Alternator)
- 101: Base Electrode
- 102: Pedestal
- 103: MOSFET Chip with a Zener Diode (or Zener Diodes) Embedded
- 104: Control IC Chip
- 105: Capacitor
- 107: Lead Electrode
- 108: Resin
- 109: Bonding Material
- 110: High Voltage Side Terminal of Capacitor
- 111: Low Voltage Side Terminal of Capacitor
- 115: Bonding Wire
- 116: Comparator
- 117: Gate Driver
- 118: Diode
- 201: n⁺ Substrate
- 202: n⁻ Epi Layer
- 203: p-Type Channel Layer
- 204: n⁺ Source Layer
- 205: p⁺ Contact Layer
- 206: p Layer
- 207: n Layer
- 208: Deep p Layer
- 209: Field Stop Layer (Channel Stopper Layer)
- 210: Trench Gate
- 211: Gate Oxide Film
- 212: Polysilicon Electrode
- 213: Trench
- 214: Interlayer Insulating Film
- 220: Source Electrode
- 221: Drain Electrode
- 222: Guard Ring
- 230: Zener Diode (ZD)
- 240: Plating Layer
- 241: Solder Layer
- 242: Protection Film
- 250: Copper Block
- 260: Active Region
- 261: Gate Pad
- 262: Source Sense Pad
- 300: Inner Package
- 302: Drain Frame
- 303, 304: Lead Frame
- 305: Resin
- 306: Bonding Material
- 400: Three-Phase Full-Wave Rectifying Circuit
- 401: Battery

## Claims

1. A semiconductor device that is equipped with a MOSFET with a Zener diode embedded, comprising:
an active region in which the MOSFET operates; and
a peripheral region that is disposed outside of the active region and holds a withstand voltage of a chip peripheral portion,
wherein the active region includes a first region including a chip central portion and a second region disposed outside the first region, and
a withstand voltage of the first region is lower than a withstand voltage of the second region and a withstand voltage of the peripheral region.

2. The semiconductor device according to claim 1,
wherein the withstand voltage of the first region is lower than the withstand voltage of the second region and the withstand voltage of the peripheral region even when a surge occurs in the semiconductor device, and a temperature of the first region rises higher than a temperature of the second region.

3. The semiconductor device according to claim 1,
wherein a plurality of unit cells are arranged in the first region and the second region,
a Zener diode is formed in each of the unit cells of the first region,
the withstand voltage of the Zener diode is lower than the withstand voltage of the second region and the withstand voltage of the peripheral region.

4. The semiconductor device according to claim 3, comprising:
a first semiconductor layer of a first conductivity type;
a second semiconductor layer of the first conductivity type that is formed on the first semiconductor layer and has a lower impurity concentration than the first semiconductor layer;
a third semiconductor layer of a second conductivity type that is formed on the second semiconductor layer;
a trench gate that penetrates the third semiconductor layer and reaches the second semiconductor layer;
a fourth semiconductor layer of the first conductivity type that is formed on the third semiconductor layer; and
a contact that penetrates the fourth semiconductor layer and reaches the third semiconductor layer,
wherein the Zener diode is formed in a central portion of a junction portion between the second semiconductor layer and the third semiconductor layer.

5. The semiconductor device according to claim 4, comprising:
a fifth semiconductor layer of the first semiconductor type in the second semiconductor layer in the vicinity of the central portion of the junction portion between the second semiconductor layer and the third semiconductor layer; and
a sixth semiconductor layer of a second conductivity type in the third semiconductor layer in the vicinity of the central portion of the junction portion between the second semiconductor layer and the third semiconductor layer.

6. The semiconductor device according to claim 5,
wherein an impurity concentration of the fifth semiconductor layer is higher than the impurity concentration of the second semiconductor layer, and an impurity concentration of the sixth semiconductor layer is higher than an impurity concentration of the third semiconductor layer.

7. The semiconductor device according to claim 1, comprising a protection film for covering the semiconductor device,
wherein the first region is disposed in an opening formed in the protection film.

8. The semiconductor device according to claim 7,
wherein the first region is disposed only just below a copper terminal for wiring provided in the opening.

9. A rectifying element used for an alternator, comprising:
a first external electrode having an outer peripheral portion that is approximately circular viewed from above and an approximately circular pedestal housed in the outer peripheral portion;
a resin-sealed inner package disposed on the pedestal; and
a second external electrode disposed on an opposite side of the first external electrode with the inner package therebetween,
the inner package including:
a semiconductor device;
a control IC chip that brings in voltages or currents of a drain electrode and a source electrode of the semiconductor device and drives a gate of the semiconductor device on the basis of the brought-in voltages or currents;
a capacitor for supplying electric power to the control IC;
a drain frame connected to the drain electrode; and
a copper block connected to the source electrode,
wherein surfaces of the drain frame and the copper block are exposed on a surface of the inner package without being resin-sealed,
the first external electrode is electrically connected to one of the drain frame and the copper block via a bonding material,
the second external electrode is electrically connected to the other of the drain frame and the copper block via a bonding material, and
the semiconductor device is a semiconductor device described in any of claim 1 to claim 8.

10. An alternator comprising the rectifying element according to claim 9.
